# EUROPÄISCHE PATENTSCHRIFT

(11) **EP 1 098 692 B1**
(45) Veröffentlichungstag und Bekanntmachung des Hinweises auf die Patenterteilung: **28.05.2003**
(21) Anmeldenummer: 99936593.5
(22) Anmeldetag: 22.07.1999
(51) Int. Cl.: B01D 46/00, H05K 7/20

(54) **SCHUTZABDECKUNG EINES GEBLÄSEKÜHLAGGREGATS**
PROTECTIVE COVER FOR A FAN-TYPE COOLING UNIT
COUVERCLE DE PROTECTION D'UN SYSTEME DE REFROIDISSEMENT A COURANT D'AIR FORCE

(30) Priorität: 23.07.1998 DE 19833247
(43) Veröffentlichungstag der Anmeldung: 16.05.2001
(73) Patentinhaber: W.L. GORE & ASSOCIATES GmbH, 85640 Putzbrunn (DE)
(72) Erfinder: GAHSE, Alfred, D-82024 Taufkirchen (DE)
(74) Vertreter: Klunker . Schmitt-Nilson . Hirsch
(86) Internationale Anmeldenummer: EP9905255
(87) Internationale Veröffentlichungsnummer: WO00004980

(56) Entgegenhaltungen:
- DE-A- 4 234 919
- US-A- 4 901 200
- US-A- 5 507 847
- US-A- 5 536 290
- US-A- 5 539 072
- US-A- 5 783 086
- PATENT ABSTRACTS OF JAPAN, Band 96, Nr. 12, 26. Dezember 1996; & JP 08 205331 A (TOSHIBA), 09. August 1996,

## Beschreibung

Die Erfindung betrifft ein Gebläsekühlaggregat und eine Schutzabdeckung eines Gebläsekühlaggregats für Bauteile zur Abdeckung von Luftdurchlaßöffnungen des Gebläsekühlaggregats, insbesondere zur Verwendung an der Witterung ausgesetzten Standorten.

Der vorliegenden Erfindung liegt das allgemeine Problem zugrunde, daß elektronische Bauteile Wärme erzeugen, die erzeugte Eigenwärme jedoch nicht dazu führen darf, daß eine Temperaturobergrenze von 65°C überschritten wird. Dieses Problem stellt sich insbesondere bei in abgeschlossenen Gehäusen aufgenommenen elektronischen Bauteilen. Je größer das Verhältnis zwischen produzierter Wärme und Gehäuseoberfläche ist, desto mehr wird die Wärmeproduktion zu einem Problem. Dies ist insbesondere bei Schaltschränken oder Basisstationen, wie sie im Telekommunikationsbereich bekannt sind, der Fall. Bei Temperaturen oberhalb von 65°C schaltet sich eine solche Basisstation automatisch ab. Aus diesem Grund müssen die elektronischen Geräte im Regelfall gekühlt werden, wozu zum Beispiel Wärmetauscher, Klimageräte und Gebläsekühlaggregate Verwendung finden.

Besonders problematisch ist die Kühlung der elektronischen Gehäuse dort, wo die Gehäuse im Freien mehr oder weniger ungeschützt und den Witterungsbedingungen ausgesetzt aufgestellt werden. Denn in einer solchen Umgebung müssen die feuchtigkeitsempfindlichen elektronischen Bauteile besonders gegen die Umwelt abgeschirmt werden. Es muß verhindert werden, daß Wasser oder Feuchtigkeit in das Gehäuse eindringen kann. Darüber hinaus müssen die elektronischen Bauteile in dem Gehäuse auch gegen Feuer mehr oder weniger geschützt sein, das heißt, das Gehäuse selbst muß hitzebeständig sein. Dies ist insbesondere für solche Standorte wichtig, wo zum Beispiel mit Buschfeuern gerechnet werden muß. Die grundlegenden Umgebungsbedingungen, denen eine solche Basisstation standhalten muß, sind in European Telecommunication Standard ETS 300 019-1-4 (Febr. 1992) angegeben.

Soweit die Wasserbeständigkeit der Gehäuse betroffen ist, wird heute von den Herstellern verlangt, daß diese einem IP Schutzwert von 55 gerecht werden (DIN 40 050), wobei die zweite Ziffer bedeutet, daß sie "Strahlwasser" standhalten müssen, das aus jeder Richtung gegen das Gehäuse gerichtet ist, ohne schädliche Wirkung auszuüben.

Es sind zur Lösung dieser Probleme im wesentlichen zwei alternative Lösungen auf dem Markt bekannt. Gemäß der ersten Lösung wird das Elektronikgehäuse mittels einem Wärmetauscher gekühlt. Dabei handelt es sich in aller Regel um einen Luft-Luft-Wärmetauscher, da ein Luft-Wasser-Wärmetauscher zu aufwendig ist, wegen der Benutzung von Wasser nicht sicher ist und in den meisten Fällen mangels eines Wasseranschlusses nur bedingt einsetzbar wäre. Die Luft-Luft-Wärmetauscher gestatten es zwar, das Gehäuse vollständig gegen Umwelteinflüsse abzudichten. Jedoch ist es meist nicht möglich, die Gehäuseinnentemperatur weiter abzukühlen als 10K über der Außentemperatur. In Temperaturzonen, wo die Außentemperatur 55°C erreicht, schafft der Luft-Luft-Wärmetauscher bestenfalls eine Gehäuseinnentemperatur von 65°C, was - wie oben erwähnt - zur Abschaltung des Geräts führt. Allgemein gilt als Faustregel, daß die Lebensdauer von Halbleitern bei Erhöhung der Betriebstemperatur um 10°C bezogen auf die maximal zulässige Betriebstemperatur um die Hälfte verkürzt wird. Daher sind die Luft-Luft-Wärmetauscher häufig nicht geeignet.

Die andere Lösung sieht eine Gebläselüftung vor. Das Gehäuse weist dazu eine Lufteintritts- sowie eine Luftaustrittsöffnung auf und darüber hinaus einen Ventilator, der für eine Luftströmung von der Lufteintrittsöffnung durch das Gebläsegehäuse zur Luftaustrittsöffnung sorgt. Durch Spritzwasserhauben wird das Eindringen von Nässe vermieden, ohne daß der Luftdurchsatz dadurch behindert würde. Jedoch läßt sich mit dieser Maßnahme der Schutzwert nur auf IP 54 erhöhen. Die Spritzwasserhauben können keine vollständige Abdichtung bieten, da sie für den Luftdurchsatz an irgendwelchen Stellen offen sein müssen. Dabei kann Feuchtigkeit z. B. in Form von Wassertröpfchen oder Aerosolen aus der Luft angesaugt werden. Der Vorteil dieser Lösung gegenüber der Luft-Luft-Wärmetauscherlösung ist dagegen, daß die erreichbare Temperaturdifferenz zwischen Außentemperatur und Gehäuseinnentemperatur wesentlich geringer ist als die mit einem Luft-Luft-Wärmetauscher erreichbare. Beide Kühlsysteme sind zum Beispiel über das Ritalwerk, Rudolf Loh GmbH & Co. KG, erhältlich.

In der GB-A-2 147 663 wird vorgeschlagen, elektronische Bauteile, die vor Schmutz, Öl oder sonstigen Partikeln geschützt werden müssen, in einem herkömmlichen zylinderförmigen Autofilter aufzunehmen und zu kühlen, indem Luft durch das zick-zack-artig gefaltete, poröse Filtermaterial des Autofilters angesaugt und über eine Leitung kontrolliert abgeführt wird.

In ähnlicher Weise ist aus der DE-A-211 268, die auf das Jahr 1972 zurückgeht, ein Gebläsekühlaggregat für eine Vorrichtung mit wärmeerzeugenden, eingesteckten Leiterplatten bekannt. Bei diesem Gebläsekühlaggregat wird die Luft durch einen herkömmlichen Filter angesaugt, durch ein die Leiterplatten enthaltendes Gehäuse geleitet und dann aus dem Gehäuse wieder herausgeführt. Diese Vorrichtung ist offensichtlich nicht für den Einsatz im Freien bestimmt. Problematisch bei der Verwendung herkömmlicher Filter ist, daß sie nicht den erforderlichen Schutz gegen Strahlwasser bieten. Außerdem setzen sie sich leicht zu und müssen dementsprechend häufig ausgewechselt werden, weil die Staubpartikel in die Tiefe der Gewebestruktur des Filters transportiert werden, wo sie an den Fasern haften bleiben. Insbesondere eine Reinigung solcher Filter ist nicht möglich.

Im Zusammenhang mit Autoscheinwerfern ist aus der DE-C-42 34 919 die Verwendung eines wasserdichten und wasserabweisenden, jedoch luft- und dampfdurchlässigen Materials bekannt, um einen geringen, passiven Luftaustausch zwischen dem Inneren des Scheinwerfers und der Atmosphäre zu gewährleisten. Dies dient unter anderem dazu, daß, wenn sich der Scheinwerfer nach Benutzung wieder abkühlt, die dann aufgrund des sich einstellenden Druckausgleichs einströmende Luft keine korrosive Feuchtigkeit in den Scheinwerfer hineintransportiert.

In der vor dem Prioritätstag der vorliegenden Erfindung angemeldeten, aber nachveröffentlichten DE-A-197 55 944 ist schließlich ein Gebläsekühlaggregat beschrieben, bei dem vor dem Lufteinlaß ein Membranfilter angeordnet ist. Die strukrürelle Ausbildung des Membranfilters bleibt darin allerdings offen.

Der vorliegenden Erfindung liegt die Aufgabe zugrunde, eine Schutzabdeckung und ein Gebläsekühlaggregat mit Schutzabdeckung vorzuschlagen, das eine von dem Gebläsekühlaggregat erreichbare Temperaturdifferenz zwischen Außentemperatur und Gehäuseinnentemperatur von unter 10K ermöglicht und einen Schutzgrad IP 55 gegen Eindringen von Wasser gewährleistet. Vorzugsweise soll die Schutzabdeckung bzw. das Gebläsekühlaggregat schwer entflammbar und temperaturbeständig sein und den in der Norm ETS (European Telecommunication Standard) 300 019-1-4 genannten Umweltbedingungen standhalten können.

Die Aufgabe wird erfindungsgemäß durch eine Schutzabdeckung als auch durch ein Gebläsekühlaggregat mit einer derartigen Schutzabdeckung gelöst, die ein wasserdichtes, poröses Material mit einer Porengröße 0,5 bis 20 µm aufweist, vorzugsweise ein textiles Flächengebilde oder insbesondere eine Membran.

Eine Porengröße von 0,5 bis 20 µm hat sich als ausreichend erwiesen, wobei eine Porengröße von 5 bis 10 µm bevorzugt wird. Durch die Verwendung von Materialien mit diesen Porengrößen wird ein effizienter und ausreichend hoher Luftdurchsatz unter Einhaltung der geforderten Randbedingungen am besten gewährleistet. Je nach Membrandicke und dem angelegten Druckgefälle über die Membran ist die Porengröße innerhalb der angegebenen Grenzen so zu wählen, daß ein gewünschter, zur Kühlung der elektronischen Bauteile ausreichender Luftdurchsatz erzielt wird. Dabei ist zu berücksichtigen, daß aufgrund von reibungsbedingten Strömungsverlusten in den Poren eine dicke Membran vergleichsweise größere Poren haben muß als eine dünne Membran, um bei einem vorgegebenen Druckgefälle, das abhängig von der Leistung des Ventilators begrenzt ist, den gewünschten Luftdurchsatz zu erzeugen. Die geringe Porengröße bietet den Vorteil, daß sich keine Partikel in das Material hineinsetzen, sondern auf der Membranoberfläche einen Filterkuchen bilden, der sich leicht abreinigen läßt.

Erfindungsgemäß ist vorgesehen, daß Luftdurchlaßöffnungen, zumindest die Lufteintrittsöffnung, vorzugsweise aber auch die Luftaustrittsöffnung oder beide Öffnungen durch eine Schutzabdeckung abgeschlossen sind, wobei die Schutzabdeckung vorzugsweise eine wasserdichte, poröse und schwer entflammbare Membran umfaßt. Als Membranmaterial kommen synthetische Polymere, wie Polyethylen, Polypropylen und Fluorpolymere einschließlich Tetrafluorethylen/(perfluoralkyl)-Vinylethercopolymer (PFA), Tetrafluorethylen/Hexafluorpropylencopoylmer (FEP) und Polytetrafluorethylen (PTFE) in Betracht, wobei PTFE zu bevorzugen ist. Die maximale Dauergebrauchstemperatur von PTFE liegt zum Beispiel bei 260°C, wobei ein kurzfristiges Überschreiten dieser Temperatur bis auf etwa 300°C möglich ist. Außerdem weist PTFE keine Versprödung bei extrem niedrigen Temperaturen, zum Beispiel -269°C von flüssigem Helium, auf. Es wird vorzugsweise gerecktes Polytetrafluoroethylen (ePTFE) verwendet.

Als textiles Flächengebilde kommen Gewebe, Gewirke oder Vliese für das Material der Schutzabdeckung in Betracht.

Das Material, als Membran oder Flächentextil, wird vorzugsweise in einem das Material umgebenden Rahmen befestigt, indem es den Rahmen entweder flach überspannt oder darin flächig angeordnet, z.B. eingespannt, ist.

Eine bevorzugte Ausführung der Schutzabdeckung sieht vor, daß das Material von einem Rahmen zur Montage in oder vor einer Lufteintrittsund/oder Luftaustrittsöffnung des Gebläsekühlaggregats umgeben ist und darin so angeordnet bzw. plissiert ist, daß sich abwechselnd Materialvorderseiten und Materialrückseiten in faltenbildender Weise gegenüberliegen. Dadurch wird eine vergrößerte Oberfläche geschaffen, ähnlich den Kühlrippen eines Wärmetauschers, um einen möglichst großen Luftdurchsatz zu ermöglichen. Die Falten sind dementsprechend in dem Rahmen so angeordnet, daß die gesamte Materialvorderseite mit der Umgebungsluft in Kontakt ist, so daß die Luft nur eine Materiallage durchdringen muß, um in das Gehäuse zu gelangen. Im Gegensatz zum eingangs beschriebenen Wärmetauscher ist die erfindungsgemäße Abdeckung wesentlich leichter und weniger voluminös.

Das plissierte Material, als Membran oder Flächentextil, kann auch nach Art eines Rundfilters in Patronenform ausgebildet sein, wobei das Gehäuse stirnseitige Abschlußkappen für das im Kreis angeordnete plissierte Material bildet.

Das Material ist mit dem Rahmen mittels einer Vergußmasse derart vergossen, daß eine hermetische Abdichtung zwischen dem Material und dem umgebenden Rahmen besteht. Dadurch wird sichergestellt, daß keinerlei Feuchtigkeit an dem Material vorbei in das Gehäuseinnere gelangen kann. Als Vergußmasse kommt Silikon, Polyurethan, Polyvinylchlorid, Epoxidharz, Kunststoffkleber und Plastisol in Betracht.

Um eine stabile Struktur zu erhalten, ist auf der Materialrückseite, das heißt an der Luftabströmseite des Materials, ein Stützmaterial vorgesehen, das vorzugsweise ein Polyestervlies ist. Dadurch bleibt die Schutzabdeckung noch ausreichend flexibel, um einfach gereinigt werden zu können. Dazu können die einzelnen Materialfaltungen notfalls auseinandergedrückt und mit Strahlwasser und ggf. mit Schwamm die Zwischenräume gereinigt werden. Dies stellt einen besonderen Vorteil gegenüber den bekannten Wärmetauschern dar, da deren Rippen üblicherweise aus Metall und häufig derart dicht nebeneinander angeordnet sind, daß ihre Reinigung zum Teil unmöglich ist. Die erfindungsgemäße Schutzabdeckung kann aufgrund dieser erhöhten Lebensdauer selbst dann noch weiterverwendet werden, wenn die Elektronik überholt und erneuerungsbedürftig ist, was gerade im Telekommunikationsbereich bereits nach zwei Jahren der Fall sein kann. Anstelle des Polyestervlieses können auch ein Gewebe, Gewirke, Gitter oder eine Lochplatte eingesetzt werden, die beispielsweise aus Polyester, Polyamid, Aramid und Fluorpolymer gefertigt sein können.

Das Stützmaterial kann mit dem Material als Laminat ausgebildet sein, wodurch die Handhabbarkeit erleichtert wird. Je nach Stützmaterial kann aber auch eine lockere Schichtung vorteilhaft sein, so daß sich die Lagen beim Falten gegeneinander leicht verschieben können.

Zusätzlich zu dem Stützmaterial auf der Materialrückseite kann ein Stützmaterial auf der Materialvorderseite aufgebracht sein. Beide Stützmaterialien können identisch sein. Jedoch sind solche Stützmaterialien für die Materialvorderseite nicht geeignet, die sich im Laufe der Zeit zusetzen und schlecht reinigen lassen.

Die Schutzabdeckung kann entweder vor oder in der Lufteintrittsöffnung angebracht sein, wobei das Einsetzen der Abdeckung in die Lufteintrittsöffnung bevorzugt wird. Zum Schutz gegen Vandalismus und mechanische Beschädigung sollte zusätzlich noch ein Kiemenblech vor die Schutzabdeckung montiert werden.

Als besonderer Vorteil hat sich herausgestellt, daß sich die vorzugsweise verwendete ePTFE-Membran selbst nach längerer Benutzung nicht zusetzt, sondern maximal eine Reduktion des Luftdurchsatzes auf 60% des Anfangswertes hinzunehmen ist. Man kann daher von einem konstanten Luftdurchsatz von mindestens 60% bei hoher Lebensdauer ausgehen.

Die ePTFE-Membranen sind von Natur aus hydrophob, können aber zusätzlich zumindest außenseitig oleophob ausgerüstet sein, was insbesondere in Ballungszentren mit hoher Luftverschmutzung und dergleichen vorteilhaft ist. Denn die Kohlenwasserstoffaerosole, Ölrückstände und übrigen Fettpartikel in der Luft können ansonsten in die Membran eindringen und eine Beeinträchtigung des Luftdurchsatzes verursachen. Auch die anderen Materialien sind vorzugsweise oleophob oder werden oleophobiert.

Soweit die verwendeten Materialien nicht natürlicherweise (auch) oleophob sind, können sie durch Behandlung mit einem oleophoben Material oleophob gemacht werden. Die Aufbringung oleophoben Materials auf das poröse Material erfolgt durch Aufbringen des oleophoben Materials in flüssiger Form, zum Beispiel als Schmelze oder Latexlösung oder - dispersion des oleophoben Materials durch Eintauchen, Bestreichen, Besprühen, Rollen oder Bürsten der Flüssigkeit auf die Oberfläche. Dies erfolgt so lange, bis die Oberfläche des porösen Materials beschichtet ist, aber nicht so lange, daß die Poren gefüllt werden, da dadurch die Luftdurchlässigkeit des porösen Materials beeinträchtigt würde. Die Gegenwart des oleophoben Materials hat daher nur einen geringen Einfluß auf die Porosität des porösen Materials. Das heißt, die Wände, die die Poren des porösen Materials definieren, sind vorzugsweise nur mit einer sehr dünnen Schicht des oleophoben Materials beschichtet.

Gängige oleophobe Zusammensetzungen sind oleophobe Fluorkohlenwasserstoffverbindungen, zum Beispiel solche die Perfluoralkylgruppen CF₃-(CF₂)n-mit n ≥ 0 enthalten. Als oleophobe Materialien können folgende Verbindungen oder Klassen verwendet werden. Apolare Perfluorpolyether (PFPE) mit CF₃-Seitengruppen, wie Fomblin Y von Ausimont und Krytox von DuPont; Mischungen aus apolaren Perfluorethern mit polaren monofunktionalen Perfluorpolyethern PFPE (Fomblin und Galden MF von Ausimont); polare, wasserunlösliche PFPE wie zum Beispiel Galden MF mit Phosphat-, Silane- oder Amidendgruppen; Mischungen aus apolarem PFPE mit fluorinierten Alkylmethacrylaten und fluorinierten Alkylacrylaten als Monomer oder in Polymerform. Die genannten Verbindungen können zum Beispiel mit UV-Strahlung in wässriger Lösung oder Emulsion vernetzt werden. Außerdem können die folgenden Materialien verwendet werden: Mikroemulsionen basierend auf PFPE (siehe EP 0 615 779, Fomblin Fe20-Mikroemulsionen); Emulsionen basierend auf Copolymeren von Siloxanen und perfluoralkylsubstituierten (Meth) Acrylaten (Hoechst); Emulsionen basierend auf perfluorinierten oder teilweise fluorinierten Co- oder Terpolymeren von denen ein Bestandteil mindestens Hexafluorpropen oder Perfluoralkylvinylether enthält; Emulsionen basierend auf perfluoralkylsubstituierten Poly(meth)acrylaten und Copolymeren (Produkte von Asahi Glass, Hoechst, DuPont und anderen); Mikroemulsionen basierend auf perfluoralkylsubstituierten Poly(meth)acrylaten und Copolymeren (US 5,539,072; US 5,460,872); Komplexen aus Polyelektrolyten und langkettigen perfluorinierten Tensiden (US 4,228,975). Bevorzugt werden diese oleophoben Polymere als wässrige Latexlösungen und werden mit einem Durchmesser der Polymerpartikel im Nanometerbereich von 0,01 bis 0,5 µm geliefert. Solche aus Mikroemulsionen gewonnenen Partikel werden beschrieben zum Beispiel in US 5,539,072 und US 5,460,872.

Weitere Vorteile und Merkmale der Erfindung werden durch die folgende Beschreibung einer besonderen Ausführungsform anhand der anhängenden Figuren deutlich werden. In den Figuren bedeuten:
Figur 1 zeigt eine Spritzschutzabdeckung gemäß der vorliegenden Erfindung;
Figur 2 zeigt einen Querschnitt durch einen Teil der Spritzschutzabdeckung aus Figur 1;
Figur 3 zeigt den Aufbau eines für die Spritzschutzabdeckung verwendeten Laminats;
Figur 4 zeigt ein erfindungsgemäßes Gebläsekühlaggregat.
Figur 5 zeigt einen dreilagigen Aufbau einer erfindungsgemäßen Spritzschutzabdeckung und
Figur 6 zeigt eine ringförmige Spritzschutzabdeckung.

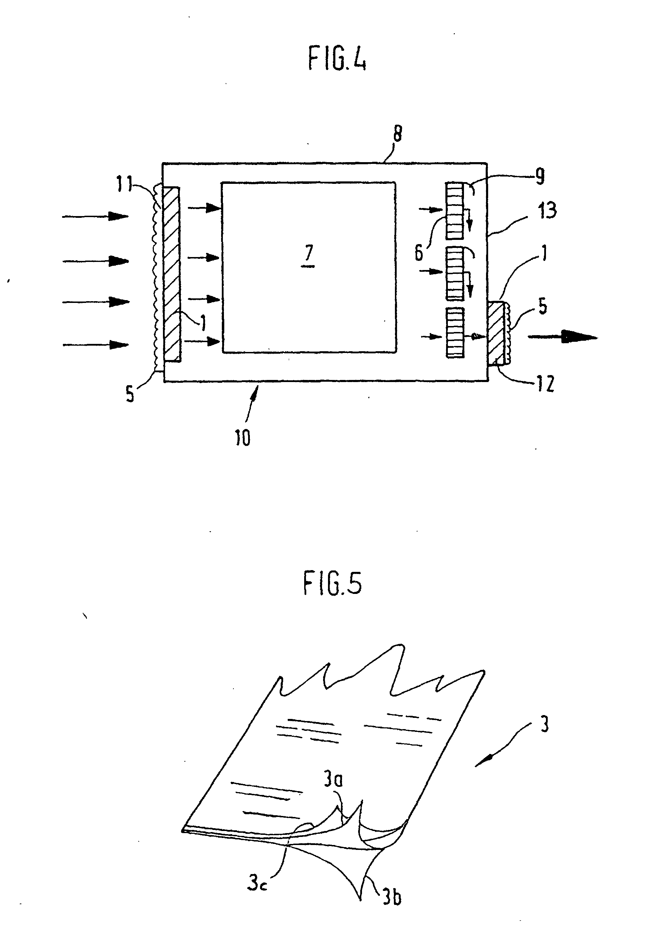

In Figur 4 ist ein Geblasekühlaggregat 10 schematisch dargestellt, in welchem elektronische Bauteile wie zum Beispiel Schaltungen, Verstärker, Halbleiter, etc. angeordnet sind, die in ihrer Gesamtheit mit 7 bezeichnet sind. Mittels einem oder mehreren Lüftern 6, die an einer Rückwand 13 des Gehäuses 8 angeordnet sind, wird ein Luftstrom erzeugt, dessen Strömungsrichtung mit Pfeilen angedeutet ist. Die Anzahl der Lüfter ist abhängig von der Größe des Gehäuses 8 und den zu kühlenden Bauelementen 7. Als Lüfter 6 kommen Axial- und Radiallüfter in Frage. Der Luftstrom tritt durch eine Lufteinlaßöffnung 11 ins Gehäuse 8 ein und durch die Luftauslaßöffnung 12 an der gegenüberliegenden Seite des Gehäuses 8 wieder aus. Die Lufteinlaß- und Luftauslaßöffnungen 11, 12 sind mit einer Schutzabdeckung 1 abgedichtet, wobei die Schutzabdeckung ein wasserdichtes, poröses Material ist, so daß die von den Lüftern 6 angesaugte Luft ausschließlich durch die Schutzabdeckung 1 und somit gefiltert durch das Material 3 hindurch ins Gehäuseinnere gelangen kann. Die Schutzabdeckungen 1 können wahlweise innerhalb oder außerhalb des Gehäuses 8 angeordnet sein, wie in Figur 4 schematisch dargestellt. Ein Kiemenblech 5 ist jeweils zum Schutz gegen mechanische Beschädigung oder Vandalismus außenseitig vor der Schutzabdeckung 1 angebracht. Die Luft wird vorzugsweise über die gesamte Vorderfläche des Gehäuses 8 angesaugt, zwischen den elektrischen Bauelementen 7 hindurchgeführt und hinter den Ventilatoren 6 mittels Leitblechen 9 zur Luftausgangsöffnung 12 geleitet. Die Leitbleche 9 helfen, einen Luftstrom in den Ecken zu verbinden und die warme Luft zu der Luftauslaßöffnung 12 zu leiten. Ein typisches Maß für ein Gehäuse 8 einer Basisstation oder eines Schaltschranks von im Außenbereich aufgestellten Telekommunikationsgeräten liegt bei 1500 x 1000 x 1000 mm³ (H x B x T), während die Schutzabdeckung 1 zum Beispiel ein Maß von etwa 1000 x 450 x 100 mm³ (H x B x T) aufweisen kann. Die Abmessungen richten sich nach der Größe des Gehäuses 8 und der zu transportierenden Luftmenge.

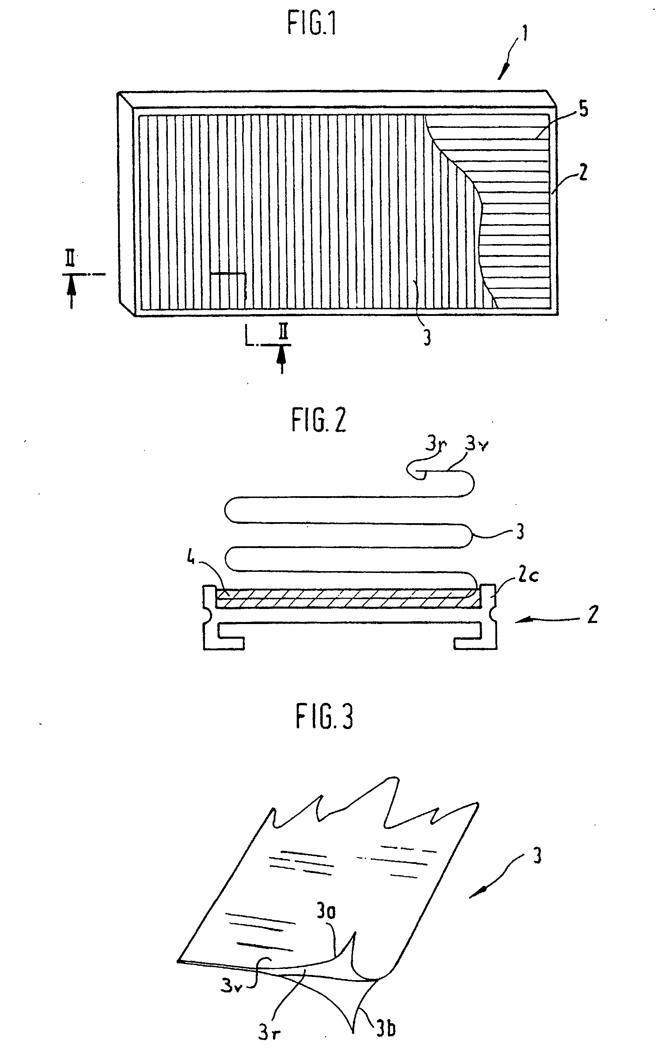

In den Figuren 1 bis 3 ist eine besondere Ausführungsform der erfindungsgemäßen Schutzabdeckung 1 dargestellt. Figur 1 zeigt einen Rahmen 2, der aus Kunststoff oder Metall hergestellt sein kann, wobei aus Stabilitäts- und Gewichtsgründen Aluminium bevorzugt wird. In dem Rahmen 2 ist eine in sich in plissierter Form gefaltetes Material 3 angeordnet. Die Faltung des Materials 3 ist zur Schaffung einer großen Luftdurchtrittsoberfläche und auch zur Eigenstabilisierung des Materials hilfreich. Wie sich aus Figur 2 ergibt, ist die Tiefe des Rahmens 2 so gewählt, daß die beiden Längsseitenkanten des gefalteten Materials 3 nicht über die Wandung 2c des Rahmens 2 übersteht, so daß eine luftdichte Verbindung zwischen dem Material 3 und dem Rahmen 2 hergestellt werden kann, um einen Luftstrom an dem Material 3 vorbei zu verhindern.

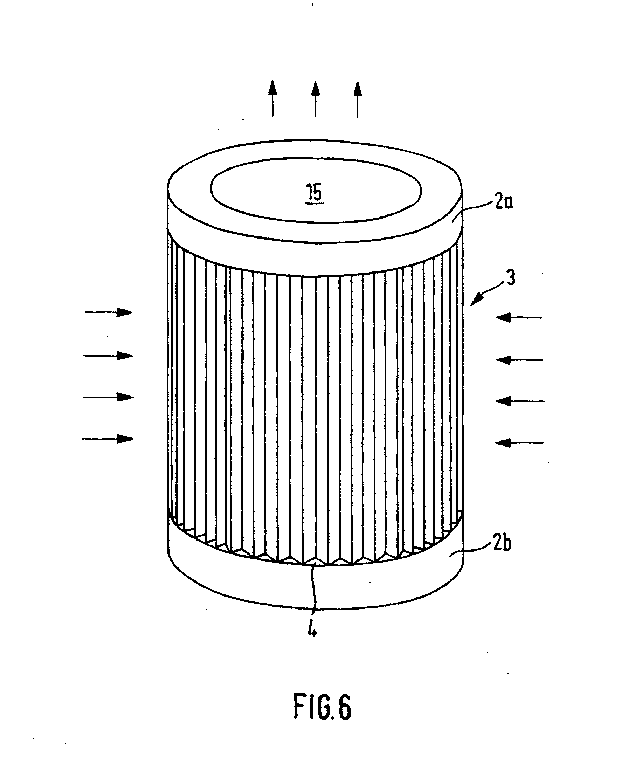

In den Figuren 1 und 2 ist ein rechteckiger Rahmen 2 mit dem darin angeordneten, in einer Ebene liegenden, plissierten Material 3 dargestellt. Alternativ kann das plissierte Material 3 im Kreis angeordnet sein, so daß die Seitenkanten durch entsprechende Abschlußkappen 2a, 2b abgeschlossen werden (Fig. 6). Der Aufbau einer solchen Abdeckung, bei dem der Rahmen 2 durch zwei Abschlußkappen 2a, 2b gebildet wird, entspricht im wesentlichen einem Ringfilter in Patronenform. Eine Abschlußkappe 2a weist eine Öffnung 15 auf, um einen Lufttransport in Pfeilrichtung zu ermöglichen. Die Abschlußkappe 2a mit der Öffnung 15 wird an das Gehäuse 8 angeschlossen.

Idealerweise wird das Material 3 in dem Rahmen 2 bzw. zwischen den Abschlußkappen mittels einer Vergußmasse 4 wie Polyurethan, Polyvinylchlorid, Epoxidharz, Silikon, heißschmelzende Klebstoffe oder Plastisol befestigt. Um eine luftdichte Abdichtung zu erreichen, sollte das Vergußmaterial 4 so gewählt oder behandelt werden, daß es das Material 3 durchtränkt oder zumindest so mit der Materialoberfläche verbindet, daß eine durchgehende Dichtung sichergestellt ist. Dafür sind zum Beispiel Silikone gut geeignet. Andere Vergußmaterialien wie Polyurethane erfordern Zusätze von Tensiden, um ein vollständiges Benetzen zu erreichen. Ebenso können Tenside im Zusammenhang mit Kunststoffen zur besseren Benetzung der Oberfläche eingesetzt werden. Bevorzugtes Vergußmaterial, das chemisch beständig ist und insbesondere von ePTFE-Membranmaterial direkt absorbiert wird, ist ein vollständig vernetztes Silikongummipolymer.

Das Vergießen des gefalteten Materials 3 mit dem Rahmen 2 erfolgt folgendermaßen. Zunächst wird das gefaltete Material 3 in den Rahmen 2 eingesetzt, und anschließend werden alle vier Wandungen 2c des Rahmens 2 mit dem Material nacheinander vergossen. Dazu ist die Wandung 2c, wie in Figur 2 zu sehen, so ausgebildet, daß sie eine Art Wanne für das Vergußmaterial 4 bildet. Nach dem Vergießen und Aushärten des Vergußmaterials 4 kann dann die nächste Wandung 2c mit dem Material 3 vergossen werden. Dabei kann das Kiemenblech 5 gleichzeitig mitvergossen werden. In Figur 1 ist ein solches Kiemenblech 5 teilweise weggebrochen dargestellt. Das gleichzeitige Vergießen macht es überflüssig, das Kiemenblech 5 an den Rahmen 2 anzukleben, anzuschrauben oder in sonstiger Weise zu befestigen. In Anwendungsfällen, bei denen ein Abreinigen des Materials 3 zu erwarten ist, ist das Vergießen des Kiemenblechs jedoch nicht sinnvoll. In diesen Fällen ist ein Verschrauben mit dem Rahmen 2 oder mit dem Gehäuse 8 (siehe Figur 4) vorzuziehen.

Das Material 3 ist porös und damit luftdurchlässig, sowie wasserdicht. Geeignet sind sowohl textile Flächengebilde, z.B. Gewebe, Gewirke oder Vliese, als auch Membranen. Bevorzugt wird eine Membran aus gereckter Polytetrafluorethylenfolie (ePTFE). Es sind jedoch auch Folien aus anderen synthetischen Polymeren wie Polyethylen, Polypropylen oder anderen Fluorpolymeren einschließlich Tetrafluorethylen/(perfluoralkyl)-Vinylethercopolymer (PFA) oder Tetrafluorethylen/Hexafluorpropylencopolymer (FEP) geeignet. Eine gereckte Polytetrafluorethylenfolie wird als Membran bevorzugt, da diese porös und wasserdicht ist, eine Temperaturbeständigkeit bis 260°C und kurzzeitig auch bis 300° besitzt, von Natur aus hydrophob ist und aufgrund einer Struktur von miteinander verbundenen Knoten und Fibrillen eine die Membrandicke durchsetzende Porosität aufweist, die einen ausreichend hohen Luftdurchsatz ermöglicht. Die Herstellung solcher gereckten Polytetrafluorethylenfolien ist detailliert in dem US-Patent 3,953,566 von Gore beschrieben, auf dessen Inhalt hier ausdrücklich Bezug genommen wird. Die Porosität und die Größe der die Membran durchsetzenden Poren wird maßgeblich durch den Grad der Reckung der Membran bestimmt. Die Verwendung einer ePTFE-Membran mit einer mittleren Porengröße von 0,5 bis 20 µm, vorzugsweise 5 bis 10 µm, insbesondere 9 µm hat sich für die erfindungsgemäße Schutzabdeckung als besonders geeignet herausgestellt, da diese Porengröße in Verbindung mit den zuvor beschriebenen Eigenschaften zu einer Schutzabdeckung führt, deren Luftdurchsatz selbst nach langem Gebrauch nicht unter 60% des Luftdurchsatzes einer neuwertigen Abdeckung sinkt.

Bevorzugt werden solche Materialien, die einem Wassereingangsdruck von mindestens 0,2 bar standhalten, wobei ein Standhalten gegenüber einem Wassereingangsdruck von größer 1 bar, wie er z.B. mit einer 0,065 mm dicken ePTFE-Membran mit 9 µm Porengröße erreichbar ist, bevorzugt wird.

Im Zusammenhang mit den beschriebenen Materialien 3 haben die genannten Eigenschaften folgende Bedeutung.

Die Porosität ergibt sich aus dem Verhältnis von scheinbarer Dichte des Materials zu spezifischer Dichte des Materials, wobei scheinbare Dichte das Verhältnis aus Gewicht zu Gesamtvolumen einschließlich Poren und Lufteinschlüsse bedeutet. Porosität bedeutet, daß das Material Poren oder Lufteinschlüsse besitzt. Diese können vollständig verschlossen sein und voneinander getrennt sein, wie zum Beispiel in einem geschlossenzelligen Schaum. Sie können aber auch miteinander verbunden sein und ein Netzwerk aus Durchgängen durch die Gesamtstruktur bilden, wie in einem offenzelligen Schaum. Es kann aber auch eine Kombination von beiden Formen vorliegen. Für die vorliegende Anwendung werden solche Strukturen bevorzugt, bei denen die Porosität weitgehend durch miteinander verbundene und die Struktur durchsetzende Zellen gebildet wird.

Die Porengröße wird durch ein Standardverfahren ermittelt, dem ASTM-Verfahren E1298-98, unter Verwendung eines Coulter Porometers™, das von Coulter Electronics Inc. hergestellt wird. Das Coulter Porometer ist ein Instrument, das ein automatischees Messen von Porengrößenverteilungen mittels dem Flüssigkeitsverdrängungsverfahren ermöglicht ("liquid displacement method"). Das Porometer bestimmt die Porengrößenverteilung einer Probe durch Luftdruckerhöhung auf die Probe und Messung der sich einstellenden Strömung. Diese Verteilung ist ein Maß für den Gleichmäßigkeitsgrad der Membran (d. h. eine enge Verteilung bedeutet eine geringe Differenz zwischen den größten und den kleinsten Porengrößen). Sie wird durch Division der maximalen Porengröße durch die minimale Porengröße ermittelt.

Das Porometer berechnet auch die mittlere Strömungsporengröße. Definitionsgemäß fließt die Hälfte des Flüssigskeitsstroms durch den Filter durch Poren, die über oder unter dieser Größe liegen. Es ist die mittlere Strömungsporengröße, die zumeist mit anderen Filtereigenschaften verknüpft ist, wie die Rückhalteeigenschaft bezüglich Partikeln in einem Flüssigkeitsstrom. Die maximale Porengröße wird häufig mit dem Bubble Point Test ermittelt, da Druckluft zuerst durch die größten Poren. hindurchströmt.

Hydrophob bedeutet, daß ein Wassertropfen auf der Oberfläche der Membran als nahezu sphärischer Tropfen bestehen bleibt mit einem Kontaktwinkel von über 90°.

Luftdurchlässig können sowohl poröse als auch nicht-poröse Materialien, insbesondere Membrane, sein, und dieser Begriff beschreibt lediglich die Eigenschaft, daß Luft durch das Material hindurch transportiert werden kann. Die erfindungsgemäße Schutzabdeckung verwendet jedoch poröse Materialien, da damit ein effektiver und ausreichend hoher Luftdurchsatz am besten gewährleistet werden kann. Der Luftdurchsatz hängt entscheidend von dem angelegten Druckgefälle, der Porengröße und der Materialdicke ab. Porengrößen zwischen 0,5 und 20 µm, vorzugsweise 5 bis 10 µm, sind praktikabel. Bei einer Porengröße von 9 µm und einer wirksamen Materialoberfläche von 6,5 m² wurde ein Luftdurchsatz von 200 m³/h erzielt, wenn im Gehäuse ein Unterdruck von 1,3 mbar erzeugt wurde. Die dabei verwendete ePTFE-Membran hatte eine Dicke von 0,065 mm. Die Dicke des Materials kann mittels Rachenlehre oder Mikrometerschraube als Mittelwert von verschiedenen Meßstellen bestimmt werden. Der Luftdurchsatz kann zum Beispiel mittels einem Gurley-Dichtemeßgerät von W. & L.E. Gurley & Sons nach dem ASTM-Testverfahren D726-58 ermittelt werden. Das Meßergebnis wird als Gurleyzahl oder Gurleysekunden angegeben. Das ist die Zeit in Sekunden, die 100 ccm benötigen, um durch ein 6,45 cm² großes Probenmaterial bei einem Druckgefälle von 12,4 cm Höhe zu fließen.

Schwer entflammbar bedeutet, daß das Material nur in einer Umgebung mit > 90% 0₂-Gehalt brennt.

Temperaturbeständig bedeutet, daß das Material sowohl bei hohen (> 100°C) als auch bei niedrigen (< -45°C) Temperaturen die wesentlichen Eigenschaften beibehält. So ist PTFE bis 260°C und kurzzeitig bis 300°C temperaturbeständig und behält selbst bei Temperaturen von flüssigem Stickstoff die wesentlichen Eigenschaften bei und versprödet insbesondere nicht.

Wasserdicht bedeutet im Sinne der vorliegenden Erfindung, daß die Schutzabdeckung einen Schutzgrad von IP-55 aufweist, das heißt, das Wasser keine schädlichen Wirkungen hat, wenn es aus jeder Richtung als Strahl gegen die Schutzabdeckung gespritzt wird. Die Wasserdichtheit eines mit der erfindungsgemäßen Schutzabdeckung mit ePTFE-Membran ausgestatteten Geräts wurde getestet, indem das Gerät in Einbaulage aufgestellt und in vier Richtungen mit einer Strahldüse jeweils für 1 Minute bespritzt wurde. Die Richtungen waren Front- und Rückseite, eine Seitenfläche sowie die Oberseite. Die Schutzabdeckung wurde aus verschiedenen Winkeln bestrahlt. Danach wurde das Gerät geöffnet, ohne daß jedoch Wasserspuren im Inneren des Geräts festgestellt werden konnten.

Der Wassereingangsdruck wird getestet, indem das Material zwischen zwei Testplatten gespannt wird. Von einer Seite wird Wasserdruck aufgebracht, und auf der anderen Seite wird mittels einem pH-Papier jeweils 10 Sekunden nach einer Druckerhöhung ein Wasserdurchbruch geprüft. Der Druck beim Wasserdurchbruch gilt als Wassereingangsdruck.

Der Begriff oleophob wird dann verwendet, wenn das Material einen Ölwert bzw. einen Ölabweisungsgrad von > 1 aufweist. Ölabwcisungsgrade von > 4 oder vorzugsweise > 8 sind dabei besonders vorteilhaft. Der Ölabweisungsgrad kann nach der AATCC-Testmethode 118-1989 ASTM bestimmt werden. Weitere Einzelheiten zum Testen der Oleophobie insbesondere poröser Membranen sind detailliert in EP 0 816 043 A1 beschrieben, auf deren Inhalt hiermit ausdrücklich Bezug genommen wird.

Um dem gefalteten Material eine höhere Steifigkeit und dennoch eine gewisse Flexibilität zu verleihen, weist das Material neben der bevorzugten ePTFE-Folie 3a ein Stützmaterial 3b auf der Materialrückseite 3r, d.h. auf der Abluftseite des Materials, auf, das als Vlies, Gewebe, Gewirke, Gitter oder Lochplatte oder eines sonstigen Flächentextils ausgebildet sein kann. Das Stützmaterial 3b ist auf der Abluftseite des Materials 3 (Materialrückseite) angeordnet, um ein Zusetzen des Stützmaterials 3b mit Schmutzpartikeln zu verhindern, was nachteilige Auswirkungen auf den Luftdurchsatz hätte. Das Stützmaterial 3b kann zum Beispiel aus Polyester, Polyamid, Aramid oder Fluorpolymer bestehen. Bevorzugt wird ein Polyestervlies. Um die Handhabbarkeit des Materials 3 zu erleichtern, können die beiden Lagen 3a, 3b miteinander laminiert werden. Vorzugsweise ist die Laminierung nur an einzelnen Stellen vorzusehen, da ansonsten der Luftdurchsatz negativ beeinflußt würde. In manchen Fällen ist jedoch eine lockere Lagenbildung zu bevorzugen, insbesondere wenn es auf einen maximalen Luftdurchsatz ankommt oder wenn aufgrund der Stützmaterialstruktur eine Relativverschiebung der beiden Lagen beim Falten gewährleistet werden muß.

Auf der Anströmseite bzw. Vorderseite 3v des Materials 3 kann ein zusätzliches Stützmaterial 3c aufgebracht sein, das grundsätzlich ähnlich aufgebaut sein kann, wie das Stützmaterial 3b auf der Abluftseite (siehe Fig. 5). Jedoch ist mit Rücksicht auf die Abreinigbarkeit der Materialoberfläche und wegen der Gefahr des Zusetzens mit Schmutzpartikel ein geeignetes Material auszuwählen. Als besonders geeignet hat sich das Material REEMAY 2250 erwiesen, das über Reemay Incorporation erhältlich ist.

Das Material 3 kann mit den Stützmaterialien 3b, 3c als 2-, 3- oder mehrlagiges Laminat ausgebildet sein.

### Beispiel

Bei Verwendung einer gereckten PTFE-Membran mit 6,5 m² wirksamer Oberfläche und einer Porengröße von 9 µm wurde ein Luftdurchsatz von 200 m³/h bei einem im Gehäuse erzeugten Unterdruck von 1,3 mbar und einer durchschnittlichen Membrandicke von 0,065 mm erreicht. Mit diesem Luftdurchsatz war es möglich, einen üblichen Telekommunikationsschaltschrank mit den Maßen 1500 x 1000 x 1000 mm³ (H x B x T) auf eine Temperatur zu kühlen, die nur 3K bis 5K über der Umgebungstemperatur lag.

Bei der Messung der erzielbaren Temperaturdifferenz mit dem erfindungsgemäßen Gebläsekühlaggregat wurden zunächst an verschiedenen wärmekritischen Punkten des Gehäuses Thermoelemente angebracht. Das Gerät wurde in einer begehbaren Klimakammer in Einbaulage aufgestellt und mit einem fest programmierten Ablauf elektrisch betrieben. Die Temperaturprüfung fand bei Umgebungstemperaturen zwischen -33°C und +55°C statt, wobei der obere Wert noch um 10° über dem European Telecommunication Standard ETS 300 019-1-4 (Feb. 1992) liegt. Die Dioden wiesen jeweils nach Temperaturangleich während des Temperaturzyklusses eine maximale Übertemperatur von 3K bis 5K gegenüber der Umgebungstemperatur auf. Auch die übrigen gemessenen Temperaturen im Inneren des Gerätes lagen in diesem Temperaturbereich.

## Patentansprüche

1. Schutzabdeckung (1) mit einem Rahmen (2), welcher zur Montage in oder vor einer Luftdurchlaßöffnung (11, 12) eines Gebläsekühlaggregats (10) für elektronische Bauteile (7) zur Abdeckung der Luftdurchlaßöffnung (11, 12) des Gebläsekühlaggregats angepaßt ist, **wobei** die Schutzabdeckung (1) ein wasserdichtes, poröses Material (3a) mit einer Porengröße von 0,5 bis 20 µm umfaßt.

2. Abdeckung nach Anspruch 1, **wobei** das Material (3a) schwer entflammbar ist.

3. Abdeckung nach Anspruch 1 oder 2, **wobei** der Rahmen (2) das Material (3a) umgibt und das Material (3a) in diesem Rahmen (2) angeordnet ist.

4. Abdeckung nach Anspruch 3, **wobei** das Material (3a) flächig im Rahmen angeordnet ist.

5. Abdeckung nach Anspruch 3, **wobei** das Material (3a) eine Materialvorderseite (3v) und eine Materialrückseite (3r) aufweist und so auf sich selbst gefaltet ist, daß sich abwechselnd Materialvorderseiten und Materialrückseiten einander gegenüberliegen und für den Luftein- bzw. -austritt offene Falten bilden.

6. Abdeckung nach Anspruch 5, **wobei** die Schutzabdeckung nach Art eines Rundfilters in Patronenform ausgebildet ist.

7. Abdeckung nach einem der Ansprüche 3 bis 6, **wobei** Seitenbereiche des Materials (3a) mittels einem Vergußmaterial (4) derart mit dem Rahmen (2) verbunden sind, daß eine hermetische Abdichtung zwischen dem Material (3a) und dem umgebenden Rahmen (2) besteht.

8. Abdeckung nach Anspruch 7, **wobei** das Vergußmaterial (4) ausgewählt wird aus einer Gruppe von Kunststoffen bestehend aus Silikon, Polyurethan, Polyvinylchlorid, Epoxidharz, Kunststoffklebern und Plastisol.

9. Abdeckung nach einem der Ansprüche 1 bis 8, **wobei** an der Materialrückseite (3r) ein Stützmaterial (3b) vorgesehen ist.

10. Abdeckung nach Anspruch 9, **wobei** zusätzlich die Materialvorderseite (3v) mit einem Stützmaterial (3c) ausgestattet ist.

11. Abdeckung nach Anspruch 9 oder 10, **wobei** das Stützmaterial (3b; 3c) ein Vlies, Gewebe, Gewirke, Gitter oder eine Lochplatte ist.

12. Abdeckung nach einem der Ansprüche 9 bis 11, **wobei** das Stützmaterial (3b; 3c) Polyester, Polyamid, Aramid, Glas oder Fluorpolymer oder ein Gewebe daraus ist.

13. Abdeckung nach Anspruch 12, **wobei** das Stützmaterial (3b) der Materialrückseite ein Polyestervlies ist.

14. Abdeckung nach einem der Ansprüche 10 bis 13, **wobei** das Stützmaterial (3c) der Membranvorderseite (3v) oleophobiert ist.

15. Abdeckung nach einem der Ansprüche 9 bis 14, **wobei** das Stützmaterial (3b) und das Material (3a) lose aufeinander liegen.

16. Abdeckung nach einem der Ansprüche 9 bis 14, **wobei** das Stützmaterzal (3b) und das Material (3a) ein Laminat (3) bilden.

17. Abdeckung nach einem der Ansprüche 1 bis 16, **wobei** das Material (3a) eine Porengröße von 5 bis 10 µm besitzt.

18. Abdeckung nach einem der Ansprüche 1 bis 17, **wobei** die Schutzabdeckung (3a) einen Luftdurchsatz von mindestens 200 m³/h zuläßt.

19. Abdeckung nach einem der Ansprüche 1 bis 18, **wobei** das Material (3a) einem Wassereingangsdruck von mindestens 0,2 bar standhält.

20. Abdeckung nach Anspruch 19, **wobei** das Material einem Wassereingangsdruck von über 1 bar standhält.

21. Abdeckung nach einem der Ansprüche 1 bis 20, **wobei** das Material (3a) eine Membran ist.

22. Abdeckung nach einem der Ansprüche 1 bis 21, **wobei** die Membran aus einem synthetischen Polymer ausgewählt aus der Gruppe Polyethylen, Polypropylen und Fluorpolymer einschließlich Tetrafluorethylen/(perfluoralkyl)-Vinylethercopolymer (PFA), Tetrafluorethylen/Hexafluorpropylencopolymer (FEP) und Polytetrafluorethylen (PTFE) besteht.

23. Abdeckung nach Anspruch 22, **wobei** die Membran eine expandierte Polytetrafluorethylen-(ePTFE)-Folie ist.

24. Abdeckung nach einem der Ansprüche 1 bis 20, **wobei** das Material (3a) ein textiles Flächengebilde ist.

25. Abdeckung nach Anspruch 24, **wobei** das textile Flächengebilde ein Gewebe, Gewirke oder Vlies ist.

26. Abdeckung nach einem der Ansprüche 1 bis 25, **wobei** das Material (3a) oleophob ausgestaltet ist.

27. Gebläsekühlaggregat (10) umfassend ein Gehäuse (8) zur Aufnahme elektronischer Bauteile (7), mindestens eine Lufteintrittsöffnung (11) und mindestens eine Luftaustrittsöffnung (12) im Gehäuse (8) sowie mindestens einen Lüfter (6) zur Erzeugung eines Luftstroms von der Lufteintrittsöffnung (11) durch das Gehäuse (8) zur Luftaustrittsöffnung (12), wobei mindestens eine Schutzabdeckung (1) zur vollständigen Abdeckung mindestens der Lufteintrittsöffnung (11) vorgesehen ist, wobei die Schutzabdeckung (1) ein wasserdichtes, poröses Material (3a) mit einer Porengröße von 0,5 bis 20 µm umfaßt.

28. Gebläsekühlaggregat nach Anspruch 27, **wobei** die Schutzabdeckung (1) in die Lufteintrittsöffnung (11) eingesetzt ist.

29. Gebläsekühlaggregat nach Anspruch 27 oder 28, **wobei** der Lüfter (6) im Gehäuse (8) an einer der Lufteintrittsöffnung (11) gegenüberliegenden Gehäusewandung (13) angeordnet ist.

30. Gebläsekühlaggregat nach einem der Ansprüche 27 bis 29, **wobei** das Gehäuse (8) ein Freiwetter-Gehäuse zur Verwendung an einem den Witterungseinflüssen ausgesetzten Standort ist.

31. Gebläsekühlaggregat nach einem der Ansprüche 27 bis 30, **wobei** außenseitig vor der Schutzabdeckung (1) ein Kiemenblech (5) angeordnet ist.

32. Verwendung eines Gebläsekühlaggregats nach einem der Ansprüche 27 bis 31 zur Kühlung elektronischer Bauelemente (7).

33. Verwendung nach Anspruch 32 für eine luftgekühlte Telekommunikationsbasisstation.

34. Verwendung einer Schutzabdeckung (1) nach einem der Ansprüche 1 bis 26 zur Abdeckung einer Luftdurchlaßöffnung (11, 12) eines Gebläsekilhlaggregats (10) für elektronische Bauteile (7).

## Claims

1. Protective covering (1) with a frame (2) which is proportioned in order to be mounted in or in front of an air vent (11, 12) of a fan cooling unit (10) for electronic components (7) to cover the air vent (11, 12) of the fan cooling unit, the protective covering (1) enclosing a waterproof, porous material (3a) with a pore size of 0.5 to 20 µm.

2. Covering according to claim 1, the material (3a) not being readily flammable.

3. Covering according to claim 1 or 2, the frame (2) encompassing the material (3a) and the material (3a) being arranged within this frame (2).

4. Covering according to claim 3, the material (3a) being arranged flat within the frame.

5. Covering according to claim 3, the material (3a) exhibiting a front face (3v) and a reverse face (3r) and being folded onto itself in such a way that alternating front faces and reverse faces of the material face one another and form open folds for the air inlet and outlet.

6. Covering according to claim 5, the protective covering being designed in the form of a cassette in the manner of a circular filter.

7. Covering according to one of claims 3 to 6, the sides of the material (3a) being connected to the frame (2) using a sealing compound (4) in such a way that a hermetic seal exists between the material (3a) and the surrounding frame (2).

8. Covering according to claim 7, the sealing compound (4) being selected from a group of plastics comprising silicone, polyurethane, polyvinylchloride, epoxy resin, plastic adhesives and plastisol.

9. Covering according to one of claims 1 to 8, a supporting material (3b) being provided on the reverse face of the material (3r).

10. Covering according to claim 9, the front face of the material (3v) additionally being equipped with a supporting material (3c).

11. Covering according to claim 9 or 10, the supporting material (3b; 3c) being a non-woven mat, woven fabric, knitted fabric, mesh or a perforated sheet.

12. Covering according to one of claims 9 to 11, the supporting material (3b; 3c) being polyester, polyamide, aramid, glass or fluoropolymer or a fabric woven therefrom.

13. Covering according to claim 12, the supporting material (3b) of the reverse face of the material being a polyester non-woven mat.

14. Covering according to one of claims 10 to 13, the supporting material (3c) of the front face of the membrane (3v) being oleophobised.

15. Covering according to one of claims 9 to 14, the supporting material (3b) and the material (3a) lying detached on top of one another.

16. Covering according to one of claims 9 to 14, the supporting material (3b) and the material (3a) forming a laminate (3).

17. Covering according to one of claims 1 to 16, the material (3a) having a pore size of 5 to 10 µm.

18. Covering according to one of claims 1 to 17, the protective covering (3a) having an air flow rate of at least 200 m³ per hour.

19. Covering according to one of claims 1 to 18, the material (3a) being resistant to a water inlet pressure of at least 0.2 bar.

20. Covering according to claim 19, the material being resistant to a water inlet pressure of over 1 bar.

21. Covering according to one of claims 1 to 20, the material (3a) being a membrane.

22. Covering according to one of claims 1 to 21, the membrane being comprised of a synthetic polymer selected from the group polyethylene, polypropylene and fluoropolymers including tetrafluoroethylene/perfluoralkyl vinyl ether copolymer (PFA), tetrafluoroethylene/hexafluoropropylene copolymer (FEP) and polytetrafluorethylene (PTFE).

23. Covering according to claim 22, the membrane being an expanded polytetrafluorethylene (ePFTE) film.

24. Covering according to one of claims 1 to 20, the material (3a) being a flat textile form.

25. Covering according to claim 24, the flat textile form being a woven fabric, knitted fabric or a non-woven mat.

26. Covering according to one of claims 1 to 25, the material (3a) having an oleophobic coating.

27. Fan cooling unit (10) comprising a casing (8) to take electronic components (7), at least one air inlet opening (11) and at least one air outlet opening (12) in the casing (8) and at least one fan (6) to produce a flow of air from the air inlet opening (11) through the casing (8) to the air outlet opening (12), at least one protective covering (1) to entirely cover at least the air inlet opening (11) being provided, the protective covering (1) comprising a waterproof, porous material (3a) with a pore size of 0.5 to 20 µm.

28. Fan cooling unit according to claim 27, the protective covering (1) being mounted in the air inlet opening (11).

29. Fan cooling unit according to claim 27 or 28, the fan (6) being fitted in the casing (8) on a casing wall (13) situated opposite the air inlet opening (11).

30. Fan cooling unit according to one of claims 27 to 29, the casing (8) being an all-weather casing for use at a location exposed to the effects of all weather conditions.

31. Fan cooling unit according to one of claims 27 to 30, a louvred panel (5) being fitted on the outside in front of the protective covering (1).

32. Use of a fan cooling unit according to one of claims 27 to 31 for cooling electronic components (7).

33. Use according to claim 32 for an air-cooled telecommunications base station.

34. Use of a protective covering (1) according to one of claims 1 to 26 to cover an air vent (11, 12) of a fan cooling unit (1) for electronic components (7).

## Revendications

1. Couvercle de protection (1) avec un cadre (2) lequel, pour son montage dans ou devant une ouverture d'arrivée d'air (11, 12) d'un système de refroidissement à courant d'air forcé (10), pour composants électroniques (7), est adapté en vue de la protection de l'ouverture de passage d'air (11, 12) du système de refroidissement à courant d'air forcé, le couvercle (1) comprenant un matériau (3a) poreux et étanche à l'eau dont la grosseur de pore est de 0,5 à 20 µm.

2. Couvercle selon la revendication 1, **caractérisé en ce que** le matériau (3a) est particulièrement ignifuge.

3. Couvercle selon la revendication 1 ou 2, **caractérisé en ce que** le cadre (2) entoure le matériau (3a) et que ce matériau (3a) est disposé dans ce cadre (2).

4. Couvercle selon la revendication 3, **caractérisé en ce que** le matériau (3a) est disposé en nappe dans le cadre.

5. Couvercle selon la revendication 3, **caractérisé en ce que** le matériau (3a) comporte un côté avant du matériau (3v) et un côté arrière du matériau (3r) et qu'il est plié sur soi-même, de sorte que les côtés avant et les côtés arrière du matériau se trouvent face à face à tour de rôle et qu'ils forment des plis pour l'entrée et la sortie de l'air.

6. Couvercle selon la revendication 5, earactérisé en ce que le couvercle de protection est configuré comme une cartouche, à la manière d'un filtre rond.

7. Couvercle selon l'une quelconque des revendications 3 à 6, **caractérisé en ce que** des secteurs latéraux du matériau (3a) sont fixés au cadre à l'aide d'un matériau de calfeutrement (4), de sorte qu'une étanchéité hermétique est donnée entre le matériau (3a) et le cadre (2) qui l'entoure.

8. Couvercle selon la revendication 7, **caractérisé en ce que** le matériau de calfeutrement (4) est sélectionné parmi un groupe de matières synthétiques comprenant la silicone, le polyuréthane, le polyvinylchlorure, la résine époxy, les colles en matière synthétique et le plastisol.

9. Couvercle selon l'une quelconque des revendications 1 à 8, **caractérisé en ce qu'**un matériau support (3b) est prévu sur le côté arrière (3r) du matériau.

10. Couvercle selon la revendication 9, **caractérisé en ce qu'**en supplément le côté avant (3v) du matériau est muni d'un matériau support (3c)

11. Couvercle selon la revendication 9 ou 10, **caractérisé en ce que** le matériau support (3b), 3c) consiste en un non-tissé, un tissu, un maillage, une grille ou une plaque perforée.

12. Couvercle selon l'une quelconque des revendications 9 à 11, **caractérisé en ce que** le matériau support (3b, 3c) consiste en du polyester, du polyamide, de l'aramide, du verre ou du fluoropolymère ou encore en un tissu.

13. Couvercle selon la revendication 12, **caractérisé en ce que** le matériau support (3b) du côté arrière du matériau est un non-tissé polyester.

14. Couvercle selon l'une quelconque des revendications 10 à 13, **caractérisé en ce que** la matériau support (3c) du côté avant de la membrane (3v) est oléophobé.

15. Couvercle selon l'une quelconque des revendications 9 à 14, **caractérisé en ce que** le matériau support (3b) et le matériau (3a) sont posés l'un sur l'autre sans être fixés.

16. Couvercle selon l'une quelconque des revendications 9 à 14, **caractérisé en ce que** le matériau support (3b) et le matériau (3a) forment un aggloméré laminé (3).

17. Couvercle selon l'une quelconque des revendications 1 à 16, **caractérisé en ce que** le matériau (3a) a une grosseur de pore de 5 à 10 µm.

18. Couvercle selon l'une quelconque des revendications 1 à 17, **caractérisé en ce que** le couvercle de protection (3a) accepte un débit d'air de 200 m³/h au minimum.

19. Couvercle selon l'une quelconque des revendications 1 à 18, **caractérisé en ce que** le matériau (3a) résiste à une pression d'entrée d'eau de 0,2 bar au minimum.

20. Couvercle selon la revendication 19, **caractérisé en ce que** le matériau résiste à une pression d'entrée d'eau supérieure à 1 bar.

21. Couvercle selon l'une quelconque des revendications 1 à 20, **caractérisé en ce que** le matériau (3a) consiste en une membrane.

22. Couvercle selon l'une quelconque des revendications 1 à 21, **caractérisé en ce que** la membrane consiste en un polymère synthétique sélectionné parmi le groupe polyéthylène, polypropylène, fluoropolymère, dont tétrafluoroéthylène/(perfluoroalkyl)-vinyléthercopolymère (PFA), tétrafluoroéthylène/hexafluoropropylènecopolymère (FEP) et polytétrafluoroéthylène (PTFE).

23. Couvercle selon la revendication 22, **caractérisé en ce que** la membrane consiste en une feuille de polytétrafluoroéthylène expansée (PTFEe).

24. Couvercle selon l'une quelconque des revendications 1 à 20, **caractérisé en ce que** le matériau (3a) consiste en un complexe textile plat.

25. Couvcrcle selon la revendication 24, **caractérisé en ce que** le complexe textile plat consiste en un tissu, un maillage ou un non-tissé.

26. Couvercle selon l'une quelconque des revendications 1 à 25, **caractérisé en ce que** le matériau (3a) est oléophobe.

27. Système de refroidissement à courant d'air forcé (10) comprenant un carter (8) pour l'installation de composants électroniques (7), au moins une ouverture d'arrivée d'air (11) et au moins une ouverture de sortie d'air (12) dans le carter (8), ainsi qu'au moins une soufflante (6) pour la génération d'un courant d'air depuis l'ouverture d'arrivée d'air (11) à travers le carter (8) jusqu'à l'ouverture de sortie d'air (12), un couvercle de protection (1) au moins étant prévu en vue de la protection intégrale de l'ouverture d'arrivée d'air (11) au moins, le couvercle de protection (1) comprenant un matériau (3a) poreux, étanche à l'eau dont la grosseur de pore est de 0,5 à 20 µm.

28. Système de refroidissement à courant d'air forcé selon la revendication 27, **caractérisé en ce que** le couvercle de protection (1) est installé dans l'ouverture d'arrivée d'air (11).

29. Système de refroidissement à courant d'air forcé selon la revendication 27 ou 28, **caractérisé en ce que** la soufflante (6) est installée dans le carter (8), sur une paroi de carter (13) située en face de l'ouverture d'arrivée d'air (11).

30. Système de refroidissement à courant d'air forcé selon l'une quelconque des revendications 27 à 29, **caractérisé en ce que** le carter (8) consiste en un carter prévu pour une utilisation à l'extérieur, sur un site exposé aux intempéries.

31. Système de refroidissement à courant d'air forcé selon l'une quelconque des revendications 27 à 30, **caractérisé en ce qu'**une tôle à branchies (5) est disposée su le côté extérieur, devant le couvercle de protection (1).

32. Mise en oeuvre d'un système de refroidissement à courant d'air forcé selon l'une quelconque des revendications 27 à 31, en vue du refroidissement de composants électroniques (7).

33. Mise en oeuvre selon la revendication 32 dans une station de base de télécommunication refroidi par air.

34. Mise en oeuvre d'un couvercle de protection (1) selon l'une quelconque des revendications 1 à 26, en vue de la protection d'une ouverture de passage d'air (11, 12) d'un système de refroidissement à courant d'air forcé (10) pour composants électroniques (7).
